# EUROPÄISCHE PATENTSCHRIFT

(11) **EP 1 407 059 B1**
(45) Veröffentlichungstag und Bekanntmachung des Hinweises auf die Patenterteilung: **27.08.2008**
(21) Anmeldenummer: 02751081.7
(22) Anmeldetag: 28.06.2002
(51) Int. Cl.: C23C 14/50, C23C 14/56, C23C 14/06, C23C 14/08, G02B 1/10

(54) **VERFAHREN UND VORRICHTUNG ZUR HERSTELLUNG EINES OPTISCH WIRKSAMEN SCHICHTSYSTEMS**
METHOD AND DEVICE FOR PRODUCING AN OPTICALLY EFFECTIVE SYSTEM OF LAYERS
PROCEDE ET DISPOSITIF DE PRODUCTION D'UN SYSTEME MULTICOUCHE D'ACTION OPTIQUE

(30) Priorität: 13.07.2001 EP 01810698
(43) Veröffentlichungstag der Anmeldung: 14.04.2004
(73) Patentinhaber: Satis Vacuum Industries Vertriebs - AG, 6340 Baar (CH)
(72) Erfinder: BREME, Frank, CH-8915 Hausen am Albis (CH)
(74) Vertreter: Schaad, Balass, Menzl & Partner AG
(86) Internationale Anmeldenummer: PCT/EP2002/007141
(87) Internationale Veröffentlichungsnummer: WO 2003/006704

(56) Entgegenhaltungen:
- DE-A- 4 117 257
- US-A- 5 427 671
- US-A- 6 143 143

## Beschreibung

Die Erfindung betrifft ein Verfahren zur Herstellung eines optisch wirksamen Schichtsystems mit den Merkmalen von Anspruch 1 sowie eine Vorrichtung zur Durchführung des Verfahrens mit den Merkmalen von Anspruch 13.

Zum Herstellen eines optischen Elements mit definierten optischen Eigenschaften ist es bekannt, ein Substrat in vorbestimmter Weise mit einem Schichtsystem aus mehreren Schichten mit unterschiedlichen optischen Eigenschaften, insbesondere unterschiedlicher Brechzahl, zu versehen. Abhängig vom Aufbau des Schichtsystems kann beispielsweise die Reflexion oder Transmission in bestimmten Wellenlängenbereichen weitgehend unterdrückt werden. Solche Schichtsysteme werden beispielsweise als Antireflex-beschichtung bei Brillengläsern oder für optische Filter oder Spiegel verwendet. Übliche Schichtmaterialien sind insbesondere Dielektrika wie Siliziumoxid oder Siliziumnitrid. Beispiele für den Aufbau von Antireflex-beschichtungen für Brillengläser sind beispielsweise in H. Pulker, Optical Coatings on Glass, 2nd edition, Elsevier, Amsterdam 1999 beschrieben. Zur Herstellung eines optischen Elements mit hoher Qualität müssen die einzelnen Schichten des Schichtsystems über die gesamte Substratfläche eine vorbestimmte Dicke aufweisen. Des weiteren muss das Substrat eine vorbestimmte Oberflächenstruktur haben.

Zur Herstellung von dünnen Schichten werden beispielsweise Sputterverfahren eingesetzt. Ein Festkörpertarget wird durch einen Ionenstrahl oder in einem Plasma mit Ionen beschossen, wodurch einzelne Atome aus dem Target gelöst werden und sich auf dem Substrat ablagern. Zur Herstellung optischer Beschichtungen ist dem Sputter-Gas, z.B. Argon, häufig ein reaktives Gas beigefügt, z.B. Sauerstoff oder Stickstoff, mit dem die sich ablagernden Atome reagieren. Es ist beispielsweise aus M. Ruske et al., Properties of Si02 and Si3N4 layers deposited by MF twin magnetron sputtering using different target materials, Thin Solid Films 351 (1999) 158-163 bekannt, mit einem einzigen Targetmaterial durch Zusatz von beispielsweise Sauerstoff oder Stickstoff als reaktivem Gas optische Schichten unterschiedlicher Zusammensetzung herzustellen, z.B. SiO₂ und Si₃N₄. Beim Sputtern kann nur die dem Target zugewandte Seite beschichtet werden. Bei einem beidseitig zu beschichtenden Substrat, z.B. einem Brillenglas, wird das Substrat daher nach der Beschichtung der Vorderseite gewendet, um die Rückseite zu beschichten.

Problematisch bei plasmagestützen Sputterverfahren zur Herstellung von optischen Schichtsystemen auf einem Substrat ist die sogenannte Rückseitenbelastung,d.h. eine Beschädigung durch z.B. Materialabtrag, Zersetzung, Kontamination und dergleichen. Während des Beschichtens einer Seite erfährt die andere Seite des Substrats durch das umgebende Plasma unerwünschte Veränderungen. Insbesondere sauerstoffhaltige Plasmen beschädigen die Substratoberfläche. Sauerstoffhaltige Plasmen werden bei allen gängigen reaktiven Sputterverfahren für die Abscheidung zumindest eines Schichtmaterials eingesetzt, z.B. von SiO₂. Die Rückseitenbelastung ist kritisch bei optischen Elementen, bei denen Vorder- und Rückseite mit einem wohldefinierten Schichtsystem versehen werden müssen. Auch kann die Oberflächenveränderung dazu führen, dass die aufgebrachte Beschichtung nicht dauerhaft haftet.

Zum Schutz der abgewandten Seite vor unerwünschten Ablagerungen ist es bekannt, das Substrat möglichst passgenau in einen Substrathalter einzusetzen, so dass die abgewandte Seite nicht in Kontakt mit dem Plasma bzw. dem Targetmaterial kommt. Dazu wird die Kontur des Substrathalters so an die Form der Oberfläche des Substrats angepasst, dass ein gegenseitiger Abstand von höchstens 2 mm (Dunkelraumabstand) besteht und sich in diesem Bereich kein Plasma bilden kann. Da die Krümmungen von ophthalmischen Linsen stark variieren, ist eine grosse Anzahl von verschiedenen Substrathaltern notwendig, die vor jedem Beschickungsvorgang überprüft und gegebenenfalls gewechselt werden müssen.

Aus der US 6 143 143 ist bekannt, die jeweils nicht besputterte Seite eines optischen Glases durch mechanische Mittel vor unerwünschten Ablagerungen zu schützen. Dazu wird vorgeschlagen, die der zu besputternden Seite abgewandte Seite entweder durch Aufkleben einer Membran oder durch Auftragen eines schützenden Gels oder Sprays zu bedecken. Als weitere Lösung wird ein Substrathalter aus einem elastischen Material vorgeschlagen, z.B. Schaumstoff oder Neopren, der sich an das Substrat anschmiegt. Nachteilig hierbei ist der hohe Aufwand, das Material aufzubringen und anschliessend zum Beschichten der anderen Seite wieder zu entfernen. Die Sputterkammer muss dazu während des Prozesses belüftet werden. Des weiteren kann Material wie die aufgeklebte Membran die Reaktionsbedingungen in der Sputterkammer stören und zu unerwünschten Ablagerungen oder Veränderungen in der Struktur der Schichten führen.

Der Erfindung liegt daher die Aufgabe zugrunde, ein plasmagestütztes Sputterverfahren zur Herstellung eines optisch wirksamen Schichtsystems auf einem flächigen Substrat anzugeben, bei welchem Beeinträchtigungen der Rückseite des Substrats bzw. des darauf abgeschiedenen Schichtsystems weitgehend vermieden werden. Des weiteren soll eine Vorrichtung zur Durchführung des Verfahrens zur Verfügung gestellt werden.

Die Aufgabe wird gelöst durch ein Verfahren mit den Merkmalen von Anspruch 1 sowie durch eine Vorrichtung mit den Merkmalen von Anspruch 12. Vorteilhafte Weiterbildungen des Verfahrens und der Vorrichtung sind in den abhängigen Ansprüche, der Beschreibung und den Zeichnungen beschrieben.

Bei einem plasmaunterstützten Sputterverfahren zur Herstellung eines optisch wirksamen Schichtsystems auf einem Substrat mit einer Vorderseite und einer Rückseite, insbesondere einem flächigen, transparenten Substrat, z.B. einem optischen Element aus Kunststoff oder Glas, wird erfindungsgemäss vor dem Beschichten der ersten Seite, z.B. der Vorderseite, auf der zweiten Seite, z.B. der Rückseite, des Substrats eine Schutzschicht aufgetragen oder ein Substrat mit einer bereits vorhandenen Schutzschicht verwendet. Nach Herstellung des Schichtsystems auf der ersten Seite wird das Substrat gegebenenfalls gewendet, um ein weiteres Schichtsystem auf der zweiten Seite abzuscheiden. Die Schutzschicht schützt das Substrat vor unerwünschten Veränderungen durch die reaktive Atmosphäre während des Beschichtens der ersten Seite. Sie kann durch eine einzelne Schicht oder durch ein auf der zweiten Seite aufgetragenes zusätzliches Schichtsystem gebildet sein. Die Schutzschicht verbleibt abgesehen vom teilweisen Abbau während des Auftragens weiterer Schichten dauerhaft auf dem Substrat. Im Gegensatz zu bekannten schützenden Folien ist die erfindungsgemässe Schutzschicht daher permanent. Da die Schutzschicht vorzugsweise in die Funktion des herzustellenden Schichtsystems integriert wird, ist kein Schritt zum Entfernen von beispielsweise einer schützenden Folie notwendig.

Bevorzugt wird die Schutzschicht auf die zweite Seite aufgesputtert. Besondere Vorteile hat das Verfahren, wenn dies innerhalb der zur Herstellung des Schichtsystems auf der ersten Seite verwendeten Vorrichtung erfolgt, da dann kein erneutes Evakuieren der Sputterkammer notwendig ist und die beiden Seiten unmittelbar nacheinander bearbeitet werden können. Nach dem Auftragen der Schutzschicht wird das Substrat vorzugsweise automatisch zum Besputtern der Vorderseite gewendet.

Die Prozessbedingungen bei der Herstellung der Schutzschicht bzw. ihre Dicke und ihr Material werden so gewählt, dass die Vorderseite des Substrats durch die Herstellung der Schutzschicht nicht beeinträchtigt wird, jedoch eine ausreichende Schutzwirkung gegeben ist, indem während der Beschichtung der ersten Seite höchstens die Schutzschicht, nicht aber das Substrat abgetragen wird. Die erste Bedingung wird vorzugsweise erfüllt, indem die Schutzschicht in einem stickstoffhaltigen Plasma abgeschieden wird und beispielsweise aus Siliziumnitrid SiₓN_{y} besteht. Gegebenenfalls kann auch ein Sauerstoffplasma zum Einsatz kommen, da die Belastung der Vorderseite durch Geringhalten der Abscheidedauer und/oder durch erhöhte Abscheidedrücke kontrollierbar ist. Bevorzugt ist eine maximale Dicke von etwa 40 nm. Die zweite Bedingung wird beispielsweise dadurch erfüllt, dass die Schutzschicht eine minimale Dicke von etwa 10 nm aufweist.

Die Schutzschicht besteht beispielsweise aus Siliziumoxid, Siliziumnitrid, Aluminiumoxid und/oder Aluminiumnitrid. Diese Materialien haben den Vorteil, dass die Schutzschicht und die weiteren hoch- und niedrigbrechenden Schichten des Schichtsystems mit einem einzigen silizium- bzw. aluminiumhaltigen Target herstellbar sind. Wenn mit unterschiedlichen Targets gearbeitet wird, kommt für die Schutzschicht grundsätzlich die erste Schicht des auf der Rückseite anzubringenden weiteren Schichtsystems in Frage, beispielsweise die gängigen hochbrechenden Materialien Titanoxid TiO₂, Zirkonoxid ZrO₂, Tantalumpentaoxid Ta₂O₅.

Bei Beschichtung beider Substratseiten dient die Schutzschicht in einer vorteilhaften Weiterbildung des Verfahrens als erste Schicht des auf der Rückseite aufzutragenden Schichtsystems. Die Herstellungsbedingungen werden so gewählt, dass die optischen Eigenschaften der Schutzschicht nach Erfüllen der Schutzfunktion an die durch das weitere Schichtsystem zu erfüllenden Vorgaben angepasst sind. Dabei wird der Materialverlust während der Vorderseiten-Beschichtung gegebenenfalls eingerechnet. Insbesondere bei Antireflex-Beschichtungen besteht die unterste Schicht üblicherweise aus einer optisch hochbrechenden Schicht, z.B. Siliziumnitrid Si₃N₄, und kann die Funktion der Schutzschicht übernehmen.

Besonders einfach ist die Durchführung des Verfahrens, wenn die Schutzschicht unter Verwendung desselben Targets hergestellt wird, das auch zur Herstellung wenigstens einzelner, vorzugsweise aller Schichten des Schichtsystems dient. In diesem Fall kann die vollständige Beschichtung einschliesslich der Schutzschicht ohne Austausch des Targets aufgesputtert werden. Die verschieden brechenden Materialien der einzelnen Schichten können durch Austausch der reaktiven Gase realisiert werden. Beispielsweise wird ein reines Silizium- oder ein Silizium-Aluminium-Target in wechselweise O₂- und N₂-haltigem Plasma eingesetzt.

Die erfindungsgemässe Vorrichtung zur Durchführung des Verfahrens umfasst eine evakuierbare Sputterkammer und einen Substrathalter mit drehbaren Aufnahmeelementen für Substrate, mit denen die Substrate sowohl um eine im wesentlichen parallel zur Substratfläche orientierte Wendeachse als auch um eine im wesentlichen senkrecht zur Substratfläche orientierte Drehachse drehbar sind. Bei einem kreisförmigen konkaven oder konvexen Substrat ist die Drehachse beispielsweise die durch den Scheitelpunkt laufende Flächennormale und die Wendeachse eine Senkrechte dazu. Durch die erfindungsgemässe Vorrichtung kann bei ortsfestem Target durch Wenden des Substrats wahlweise die Vorderseite oder die Rückseite der Substrate besputtert werden kann, ohne die Sputterkammer zu öffnen. Die Drehbewegung dient zur Erzeugung einer homogenen und gleichmässigen Schichtdickenverteilung. Besonders bevorzugt werden beide Bewegungen mit demselben Antrieb realisiert.

Neben der vollständigen Beschichtung beider Substratseiten in einer einzigen Anlage eignet sich die Erfindung hervorragend zur Endfertigung von "semi-finished" oder "finished" Linsen durch den Optiker durch Aufbringen der vom Kunden gewünschten Beschichtungen. Hierbei fungiert erfindungsgemäss eine bereits auf dem Substrat vorhandene Beschichtung als Schutzschicht.

Bei sogenannten "semi-finished" Linsen hat die Vorderseite vom Werk aus bereits eine bestimmte Form mit den gewünschten optischen Eigenschaften, während die Rückseite vom Optiker durch Schleifen individuell so mechanisch bearbeitet wird, dass die Linse die im Einzelfall bestehenden Vorgaben, z.B. hinsichtlich Brechkraft und/oder Zylinder, erfüllt. Die Beschichtungen sind bei solchen Linsen ebenfalls vom Optiker anzubringen. Gemäss der Erfindung wird bei einer solchen Linse zunächst ein vollständiges Antireflex-Schichtsystem auf der Vorderseite, in diesem Fall der "zweiten" Seite gemäss Anspruch 1, aufgetragen das als Schutzschicht fungiert. Die bei dessen Herstellung auftretende Rückseitenbelastung wird durch die nachträgliche mechanische Bearbeitung der Rückseite eliminiert. Anschliessend wird ein Antireflex-Schichtsystem auf die Rückseite, in diesem Fall der "ersten" Seite gemäss Anspruch 1, aufgesputtert. Dabei ist die Vorderseite durch die zuvor aufgebrachte komplette Antireflex-Beschichtung geschützt. Bevorzugt wird das als Schutzschicht wirkende Schichtsystem auf die Vorderseite aufgesputtert. Die Vorderseitenbeschichtung kann jedoch auch herstellerseitig in einer separaten Grossanlage, z.B. in einem sogenannten Boxcoater, durchgeführt werden. Dabei kann das Schichtsytem auch mittels Elektronenstrahlverdampfen hergestellt werden.

Als Alternative zum oben geschilderten Ablauf kann die Rückseite ("erste" Seite) mechanisch komplett bearbeitet werden, bevor die Vorderseite ("zweite" Seite) mit dem als Schutzschicht wirkenden Schichtsystem beschichtet wird. Nach dem Aufbringen der Schutzschicht wird auf der eventuell belasteten Rückseite ein Hartlack zur Verbesserung der Kratzfestigkeit aufgebracht. Dieser Hartlack hat keine Haftungsprobleme auf einer eventuell belasteten Oberfläche, stellt jedoch eine unbelastete neue Oberfläche für das anschliessend aufgesputterte Schichtsytem dar. Mit diesem Verfahren können auch sogenannte "finished" Linsen, d.h. solche mit herstellerseitig vorgegebenen Optik ohne mechanische Nachbearbeitung, die keinen Hartlack auf der Rückseite besitzen, beschichtet werden.

Es versteht sich, dass Material und Dicke des bereits auf als Schutzschicht wirkenden Schichtsystems bzw. dessen oberster Schicht wie oben beschrieben so gewählt werden, dass die optischen Eigenschaften durch die Belastung beim Auftragen des eigentlichen Schichtsystems auf der anderen Seite nicht beeinträchtigt bzw. in kontrollierter Weise verändert werden.

Weitere Ausführungsbeispiele der Erfindung sind in den Zeichnungen dargestellt, wobei rein schematisch zeigen:
- Fig. 1A-E: die einzelnen Verfahrensschritte beim Beschich-ten von Vorder- und Rückseite eines Substrats;
- Fig. 2: ein erfindungsgemässer Substrathalter in 3D-Ansicht in Arbeitsposition (Beschichten);
- Fig. 3: der Substrathalter gemäss Fig. 2 in Wendepositi-on;
- Fig. 4: den Substrathalter aus Fig. 2 im Längsschnitt in Arbeitsposition;
- Fug. 5: den Substrathalter aus Fig. 2 im Längsschnitt in Wendeposition.

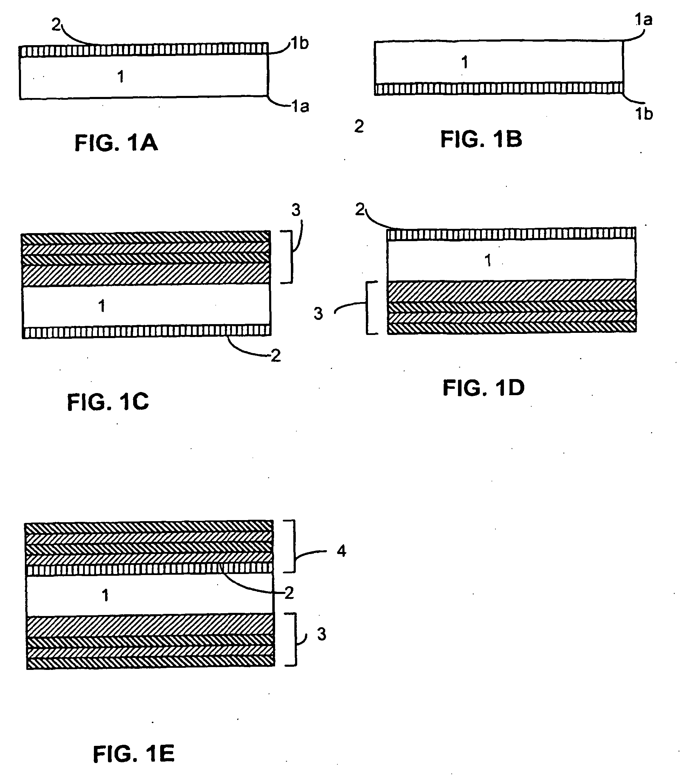

Anhand von Fig. 1A-E wird im folgenden ein Verfahrensbeispiel für die Beschichtung von flächigen, transparenten Substraten 1, insbesondere Brillengläsern, mit einer Antireflex-Schicht 3, 4 auf der Vorderseite 1a ("erste" Seite) und der Rückseite 1b ("zweite" Seite) beschrieben. Die in den Figuren gezeigten Abmessungen sind rein schematisch; auch ist die häufig vorhandene Krümmung des Substrats 1 nicht gezeigt.

Typische Gasflüsse liegen im Bereich von beispielsweise 2 bis 50 sccm (Standard-Kubikzentimeter), können je nach Anwendungsfall und eingesetzter Pumpe auch kleiner oder grösser sein. Der daraus resultierende Druck in der Beschichtungskammer liegt im Bereich 5.10⁻² bis 8.10⁻⁴ mbar. Die Plasmaleistung beträgt beispielsweise etwa 1,0 - 2,5 KW.

Als Sputterverfahren wird das gepulste DC-Sputtern eingesetzt. Dabei wird das Plasma mit einem Elektronen-Gleichstrom erzeugt, der mit einer bestimmten Frequenz ein- und ausgeschaltet wird. Während einer Periode ist das Plasma jeweils für eine bestimmte Zeit (Pulse pause time PPT) ausgeschaltet.

Die einzelnen Schichten der Schichtsysteme 3, 4 werden jeweils nach folgendem Schema abgeschieden: Zunächst werden die Gasflüsse eingestellt. Nach einer kurzen Wartezeit, z.B. 10 s, wird das Plasma gezündet. Ein Shutter zwischen Target und Substrat 1 wird nach einer zur Plasmastabilisierung genutzten weiteren Wartezeit, z.B. 10 s, für die, vorgegebene Beschichtungsdauer geöffnet und anschliessend geschlossen.

Zuerst wird die konkave Seite 1b mit einer erfindungsgemässen Schutzschicht 2 aus Si_{X}N_{Y} besputtert. Dazu werden beispielsweise folgende Prozessparameter gewählt:
10 sccm Ar₂, 30 sccm N₂, Leistung: 1750 W, Frequenz: 90 kHz, Pulse reverse time (PPT): 5 µs. Bei einer Beschichtungsdauer von 22 s wird eine 15 nm dicken Si_{X}N_{Y}-Schicht 2 abgeschieden (Fig. 1A).

Anschliessend wird das Substrat 1 gewendet (Fig. 1B) und die konvexe Seite 1a in an sich bekannter Weise mit einem Antireflex-Schichtsystem 3 beschichtet, das hier aus vier Schichten besteht (Fig. 1C). Ein typisches Schichtsystem umfasst von innen nach aussen beispielsweise 35 nm Si_{X}N_{Y}, 20 nm SiO₂, 61 nm Si_{X}N_{Y}, 92 nm SiO₂.

Für die Si_{X}N_{Y}-Schichten werden die Prozessparameter mit Ausnahme der Beschichtungsdauer beispielsweise entsprechend der Parameter für die Herstellung der Schutzschicht gewählt.

Für die SiO₂-Schichten werden beispielsweise folgende Parameter gewählt: 10 sccm Ar₂, 25 sccm O₂; 1750 W, 90 kHz, 5 µs PPT

Die Beschichtungszeiten (Shutter in der Stellung "offen") betragen für die Schichten von innen nach aussen beispielsweise: 1. 41 s, 2. 25 s, 3. 72 s, 4. 115 s.

Nach dem Abscheiden des vollständigen Schichtsystems auf der konvexen Seite wird das Substrat erneut gewendet (Fig. 1D) und die konkaven Seite 1b mit dem restlichen Antireflex-Schichtsystem 4 beschichtet (Fig. 1E), das mit dem Schichtsystem 3 der konvexen Seite 1a identisch ist. Von der Schutzschicht wurden durch die Rückseitenbelastung des Plasmas etwa 5 nm abgetragen, so dass noch 10 nm Si_{X}N_{Y} verbleiben (Dickenverlust nicht dargestellt). Es werden damit als erste Schicht 25 nm Si_{X}N_{Y} abgeschieden, dann folgen wie beschrieben die übrigen drei Schichten. Dies ist schematisch dadurch angedeutet, dass die an die Schutzschicht 2 in Fig. 1 angrenzende Schicht gegenüber der entsprechenden inneren Schicht des Schichtsystems 3 eine geringere Dicke aufweist. Die Beschichtungsraten sind aufgrund des grösseren Abstandes der konkaven Linsenseite zum Target um ca. 10 % kleiner.

Die Beschichtungszeiten betragen für die Schichten von innen nach aussen beispielsweise: 1. 32 s, 2. 27 s, 3. 79 s, 4. 126 s.

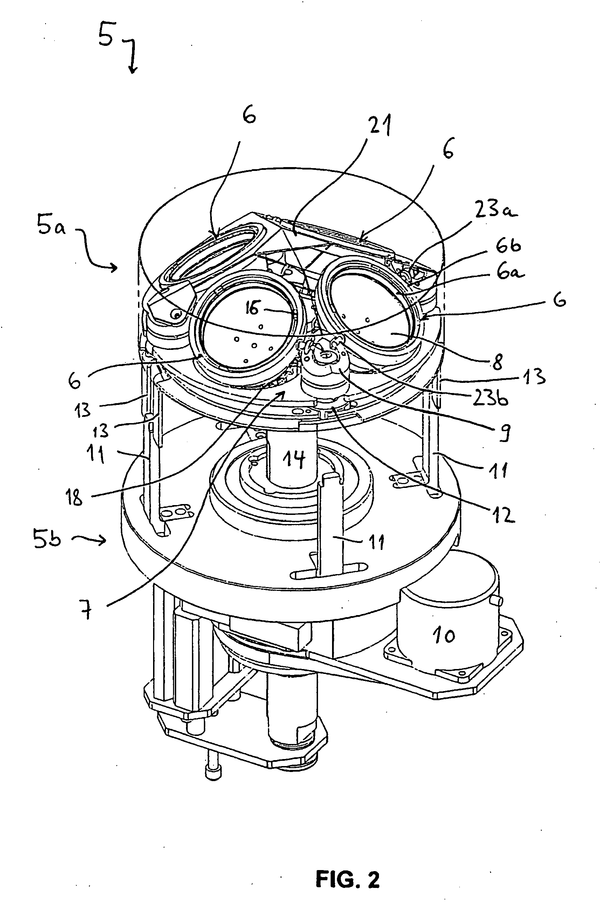

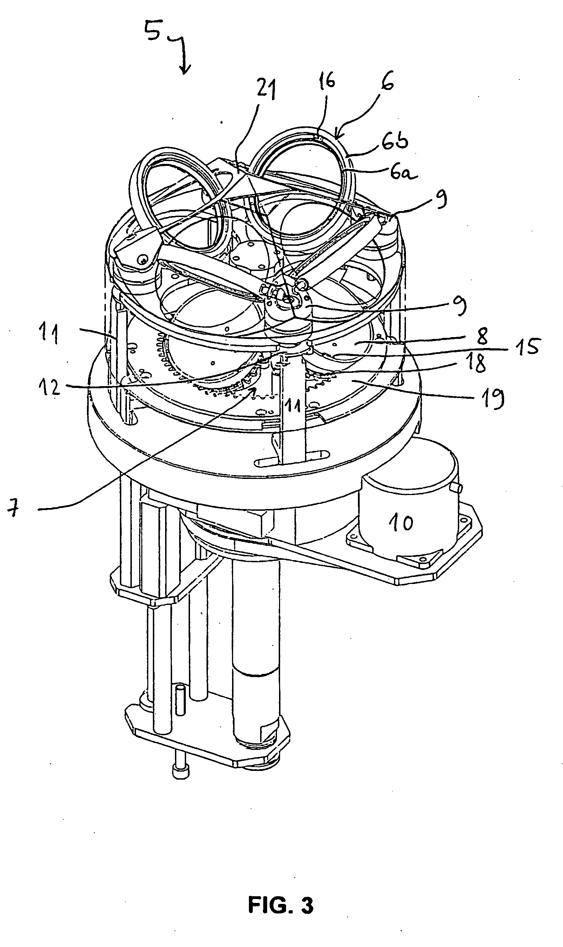

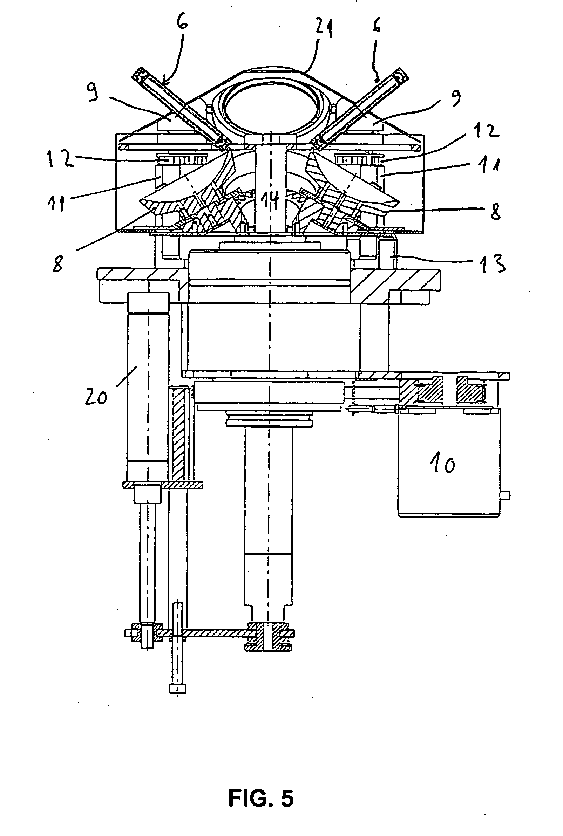

In den Figuren 2-5 ist ein Substrathalter 5 als Kernstück einer erfindungsgemässen Vorrichtung dargestellt. Neben dem erfindungsgemässen Beschichtungsverfahren kann er bei sämtlichen Beschichtungsvorgängen eingesetzt werden, bei denen ein Substrat im Vakuum sowohl gedreht als auch gewendet werden muss.

Der Substrathalter 5 umfasst vier ringförmige Aufnahmeelemente 6, in die das Substrat, beispielsweise ein Brillenglas, so eingesetzt werden kann, dass seine Hauptoberflächen bzw. die Vorder- und Rückseite zugänglich sind. Die Aufnahmeelemente 6 bestehen aus einem inneren Ring 6a und einem äusseren Ring 6b, die relativ zueinander verdrehbar sind. Der innere Ring 6a weist Nocken 16 auf, mit denen er in Drehung relativ zum äusseren Ring versetzt werden kann. Der äussere Ring 6b weist an seinem Umfang zwei Stifte 23a, 23b auf, mit denen er in der Abdeckung 21 des Substrathalters 5 gelagert ist. Die Stifte 23a, 23b definieren die Wendeachse. Einer der Stifte 23a ist mit einem Ankopplungselement, z.B. einem Zahnrad, versehen und wirkt mit einem Wendeantrieb 9 zusammen (siehe unten).

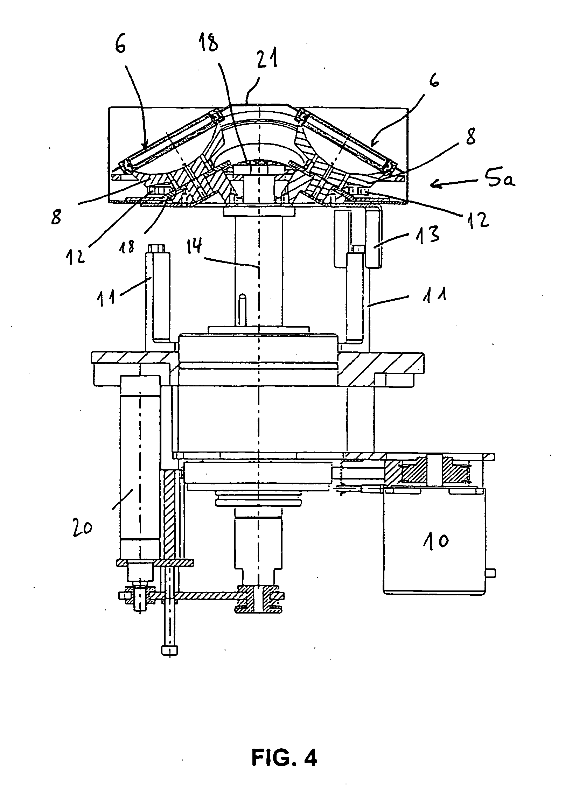

Die Aufnahmeelemente 6 liegen in der Arbeitsposition (Fig. 2 und 4) auf Aufnahmeschalen 8 auf. Diese sind Teil eines Planetengetriebes 7 und werden durch einen Antrieb 10 in eine Drehbewegung versetzt. Diese Bewegung wird durch den Nocken 16 am inneren Ring 6a und Nocken 15 an den den Aufnahmeschalen 8 auf den inneren Ring 6a der Aufnahmeelemente 6 übertragen. Das Planetengetriebe 7 wird angetrieben, indem eine mit den Aufnahmeschalen 8 gekoppelte Welle 14 durch den Antrieb 10 gedreht wird. Die Aufnahmeschalen 8 sind um ihre Längsachse drehbar und werden gedreht, indem bei der Rotation der Welle Zahnkränze 18 an den Aufnahmeschalen 8 an einem nicht mitdrehenden äusseren Planetenrad 19 abrollen. Das äussere Planetenrad 19 wird festgehalten, indem es wenigstens mittelbar mit nach unten ragenden Kulissen 13 verbunden ist, mit denen ein drehfest am unteren Teil 5b des Substrathalters 5 angeordneter Schaltzapfen 11 zusammenwirkt. Durch einen Hubzylinder 20 ist der obere Teil 5a des Substrathalters 5 relativ zum unteren Teil 5b verschiebbar.

In der Arbeitsposition ist der Abstand derart, dass zwar die Schaltzapfen 11 mit der Kulisse 13 zusammenwirken, so dass das Planetengetriebe in Gang gesetzt wird, jedoch die Schaltzapfen 11 nicht bis in den Bereich der äusseren Planetenscheibe 19 ragen. Damit werden die Aufnahmeelemente 6 in der Arbeitsposition wie beschrieben um eine durch ihren Mittelpunkt verlaufende Drehachse gedreht.

Zum Wenden der Aufnahmeelemente wird der Abstand zwischen dem oberen und dem unteren Teil 5a, 5b verringert. Die Schaltzapfen 11 greifen nun in den oberen Teil 5a ein und drücken dessen Abdeckung 21, in der die Aufnahmeelemente 6 gelagert sind, nach oben. Die Aufnahmeelemente 6 werden so aus den Aufnahmeschalen 8 gehoben und nicht weiter gedreht. In dieser Stellung sind die Ankopplungselemente der Aufnahmeelemente 6 sind im Eingriff mit jeweils einem Wendeantrieb 9. Dieser ist mit jeweils einem Schaltteller 12 verbunden. Indem der Schaltzapfen 11 in der Wendeposition (geringer Abstand der Teile 5a, 5b) bei Rotation der Welle und damit der Wendeantriebe 9 um die Wellenlängsachse periodisch gegen die Schaltteller 12 bzw. einen daran angeordneten Nocken stösst, wird der Wendeantrieb in eine Drehbewegung um seine eigene Längsachse versetzt. Diese Drehbewegung wird durch das Ankopplungselement in die Wendebewegung der Aufnahmeelemente 6 umgesetzt.

Im Anwendungsfall befinden sich im wesentlichen nur der obere Teil 5a und die Schaltzapfen 11 innerhalb der Sputterkammer. Durch den gemeinsamen Antrieb 10 muss lediglich eine Durchführung gegeneinander beweglicher Bauteile, hier die Welle 14 und die sie umgebenden Hülsen, aus der Vakuumkammer realisiert und abgedichtet werden.

Mit dem beschriebenen Substrathalter 5 lässt sich das erfindungsgemässe Verfahren schnell und ohne zwischenzeitliches Belüften durchführen. Indem mehrere Substrate gleichzeitig beschichtet und gewendet werden können, lässt sich ein hoher Durchsatz erzielen.

## Patentansprüche

1. Verfahren zur Herstellung eines optisch wirksamen Schichtsystems (3) auf einem Substrat (1) mit einer ersten Seite (1a) und einer zweiten Seite (1b) durch plasmaunterstütztes Zerstäuben eines Festkörper-targets (Sputtern), wobei auf der zweiten Seite (1b) des Substrats (1) eine Schutzschicht (2) aufgetragen wird oder ein Substrat (1) mit einer bereits aufgetragenen Schutzschicht (2) verwendet wird und dass auf der ersten Seite (1a) des Substrats (1) das Schichtsystem (3) aufgesputtert wird, **dadurch gekennzeichnet, dass** die Schutzschicht (2) derart gewählt ist oder hergestellt wird, dass ihre optischen Eigenschaften an die durch ein weiteres Schichtsystem (4) zu erfüllenden Vorgaben angepasst sind.

2. Verfahren nach Anspruch 1, **dadurch gekennzeichnet, dass** die Schutzschicht (2) durch eine einzelne Schicht oder durch ein auf der zweiten Seite (1b) aufgetragenes zusätzliches Schichtsystem gebildet ist.

3. Verfahren nach Anspruch 1 oder 2, **dadurch gekennzeichnet, dass** nach der Herstellung des Schichtsystems (3) auf der ersten Seite (1a) ein weiteres Schichtsystem (4) auf der zweiten Seite (1b) aufgesputtert wird, vorzugsweise innerhalb der zur Herstellung des Schichtsystems (3) verwendeten Vorrichtung.

4. Verfahren nach einem der vorangegangenen Ansprüche, **dadurch gekennzeichnet, dass** die Schutzschicht (2) auf der zweiten Seite (1b) aufgesputtert wird, vorzugsweise innerhalb der zur Herstellung des Schichtsystems (3) verwendeten Vorrichtung.

5. Verfahren nach Anspruch 4, **dadurch gekennzeichnet, dass** die Schutzschicht (2) unter Verwendung eines im wesentlichen sauerstofffreien Plasmas aufgesputtert wird.

6. Verfahren nach einem der Ansprüche 4 oder 5, **dadurch gekennzeichnet, dass** die Schutzschicht (2) unter Verwendung desselben Targets hergestellt wird, das auch zur Herstellung wenigstens einzelner Schichten des Schichtsystems (3, 4) dient.

7. Verfahren nach Anspruch **dadurch gekennzeichnet, dass** zur Herstellung der Schutzschicht (2) und der Schichten des Schichtsystems (3, 4) dasselbe Target verwendet wird, wobei das Prozessgas zur Herstellung des Plasmas in Abhängigkeit von der herzustellenden Schicht ausgetauscht wird.

8. Verfahren nach einem der vorangegangenen Ansprüche, **dadurch gekennzeichnet, dass** die Schutzschicht (2) aus Siliziumoxid, Siliziumnitrid, Aluminiumoxid und/oder Aluminiumnitrid besteht.

9. Verfahren nach einem der vorangegangenen Ansprüche, **dadurch gekennzeichnet, dass** die Schutzschicht (2) mit einer Dicke von 10 bis 40 nm aufgetragen wird.

10. Verfahren nach einem der vorangegangenen Ansprüche, **dadurch gekennzeichnet, dass** das Material der Schutzschicht (2) und ihre Dicke in Abhängigkeit von den Prozessparametern beim Auftragen des Schichtsystems (3) auf der Vorderseite (1a) so gewählt werden, dass nach dem Auftragen dieses Schichtsystems (3) eine Schutzschicht (2) mit einer vorbestimmten Dicke vorhanden ist.

11. Verfahren nach einem der vorangegangenen Ansprüche, **dadurch gekennzeichnet, dass** ein als Schutzschicht (2) wirkendes Schichtsystem auf die zweite Seite (1b) aufgebracht wird bzw. ein Substrat mit einem solchen Schichtsystem verwendet wird, die erste Seite (1a) zuerst zum Erzielen von vorbestimmten optischen Eigenschaften mechanisch bearbeitet wird und anschliessend das Schichtsytem (3) auf die erste Seite (1a) aufgetragen wird.

12. Vorrichtung zur Durchführung des Verfahrens nach einem der vorangegangenen Ansprüche mit einer evakuierbaren Sputterkammer und einem Substrathalter (5) mit Aufnahmeelementen (6) für Substrate (1), mit denen die Substrate (1) sowohl um eine im wesentlichen parallel zur Substratfläche orientierte Wendeachse als auch um eine im wesentlichen senkrecht zur Substratfläche orientierte Drehachse drehbar sind , **dadurch gekennzeichnet, dass** die Wende achse mit einem Ankopplungselement versehen ist, welches mit einem Wendeantrieb (9) derart zusammenwirkt, dass durch ein automatisches Wenden des Substrats (1) das Verfahren auf die erste Seite (1a) und die zweite Seite (1b) des Substrats (1) angewendet werden kann, ohne die Sputter kommerzwischen zeitlich zu belüftenzwischen zeitlich zu belüftenzwischen zeitlich zu belüften.

13. Vorrichtung nach Anspruch 12, **dadurch gekennzeichnet, dass** ein gemeinsamer Antrieb (10) für die Drehbewegung und die Wendebewegung vorhanden ist.

## Claims

1. Method for producing an optically effective system of layers (3) on a substrate (1) having a first side (1a) and a second side (1b) by plasma-enhanced atomization of a solid target (sputtering), wherein a protective layer (2) is applied to the second side (1b) of the substrate (1) or a substrate (1), with a protective layer (2) which has already been applied is used, and in that the system of layers (3) is sputtered onto the first side (1a) of the substrate (1), **characterized in that** the protective layer (2) is selected or produced in such a manner that its optical properties are matched to the conditions which are to be satisfied by a further system of layers (4).

2. Method according to Claim 1, **characterized in that** the protective layer (2) is formed by a single layer or by an additional system of layers applied to the second side (1b).

3. Method according to Claim 1 or 2, **characterized in that** after the system of layers (3) has been produced on the first side (1a), a further system of layers (4) is sputtered onto the second side (1b), preferably inside the device used to produce the system of layers (3).

4. Method according to one of the preceding claims, **characterized in that** the protective layer (2) is sputtered onto the second side (1b), preferably inside the device used to produce the system of layers (3).

5. Method according to Claim 4, **characterized in that** the protective layer (2) is sputtered on using a substantially oxygen-free plasma.

6. Method according to one of Claims 4 or 5, **characterized in that** the protective layer (2) is produced using the same target which is also used to produce at least some layers of the system of layers (3, 4).

7. Method according to Claim 6, **characterized in that** the same target is used to produce the protective layer (2) and the layers of the system of layers (3, 4), the process gas for producing the plasma being exchanged as a function of the layer which is to be produced.

8. Method according to one of the preceding claims, **characterized in that** the protective layer (2) consists of silicon oxide, silicon nitride, aluminum oxide and/or aluminum nitride.

9. Method according to one of the preceding claims, **characterized in that** the protective layer (2) is applied with a thickness of 10 to 40 nm.

10. Method according to one of the preceding claims, **characterized in that** the material of the protective layer (2) and its thickness are selected in such a way, as a function of the process parameters during application of the system of layers (3) to the front side (1a), that after this layer system (3) has been applied there is a protective layer (2) with a predetermined thickness.

11. Method according to one of the preceding claims, **characterized in that** a system of layers which acts as a protective layer (2) is applied to the second side (1b) or a substrate having a system of layers of this type is used, the first side (1a) is firstly machined in order to obtain predetermined optical properties, and then the system of layers (3) is applied to the first side (1a).

12. Device for carrying out the method according to one of the preceding claims, having an evacuable sputtering chamber and a substrate holder (5) with receiving elements (6) for substrates (1), by means of which the substrate (1) can be rotated both about a turning axis, which is oriented substantially parallel to the substrate surface, and about an axis of rotation, which is oriented substantially perpendicularly to the substrate surface, **characterized in that** the turning axis is provided with a coupling element which interacts with a turning drive (9) in such a manner that by automatic turning of the substrate (1) the method can be applied to the first side (1a) and the second side (1b) of the substrate (1) without the need for interim venting of the sputtering chamber.

13. Device according to Claim 12, **characterized in that** there is a common drive (10) for the rotary movement and the turning movement.

## Revendications

1. Procédé de fabrication d'un système stratifié (3) à effets optiques sur un substrat (1) qui présente un premier côté (1a) et un deuxième côté (1b), par pulvérisation soutenue par plasma d'une cible constitué d'un corps solide (pulvérisation), dans lequel une couche de protection (2) est appliquée sur le deuxième côté (1b) du substrat (1) ou dans lequel on utilise un substrat (1) sur lequel une couche de protection (2) a déjà été appliquée, le système de couches (3) étant pulvérisé sur le premier côté (1a) du substrat (1),
**caractérisé en ce que**
la couche de protection (2) est sélectionnée ou formée de telle sorte que ses propriétés optiques soient adaptées aux exigences qui doivent être satisfaites par un autre système de couches (4).

2. Procédé selon la revendication 1, **caractérisé en ce que** la couche de protection (2) est formée d'une seule couche ou d'un système supplémentaire de couches appliqué sur le deuxième côté (1b).

3. Procédé selon les revendications 1 ou 2, **caractérisé en ce qu'**après la réalisation du système de couches (3) sur le premier côté (la), on pulvérise un autre système de couches (4) sur le deuxième côté (1b), de préférence à l'intérieur du dispositif utilisé pour réaliser le système de couches (3).

4. Procédé selon l'une des revendications précédentes, **caractérisé en ce que** la couche de protection (2) est pulvérisée sur le deuxième côté (1b) de préférence à l'intérieur du dispositif utilisé pour la réalisation du système de couches (3).

5. Procédé selon la revendication 4, **caractérisé en ce que** la couche de protection (2) est pulvérisée en recourant à un plasma essentiellement exempt d'oxygène.

6. Procédé selon l'une des revendications 4 ou 5, **caractérisé en ce que** la couche de protection (2) est réalisée en utilisant la même cible que celle qui sert également à réaliser au moins certaines couches du système de couches (3, 4).

7. Procédé selon la revendication 6, **caractérisé en ce qu'**on utilise la même cible pour réaliser la couche de protection (2) et les couches du système de couches (3, 4) et **en ce qu'**on remplace le gaz de traitement utilisé pour former le plasma en fonction de la couche à réaliser.

8. Procédé selon l'une des revendications précédentes, **caractérisé en ce que** la couche de protection (2) est constituée d'oxyde de silicium, de nitrure de silicium, d'oxyde d'aluminium et/ou de nitrure d'aluminium.

9. Procédé selon l'une des revendications précédentes, **caractérisé en ce que** la couche de protection (2) est appliquée à une épaisseur de 10 à 40 nm.

10. Procédé selon l'une des revendications précédentes, **caractérisé en ce que** lors de l'application du système de couches (3) sur le côté avant (la), le matériau de la couche de protection (2) et son épaisseur sont sélectionnés en fonction des paramètres de traitement de telle sorte qu'on obtienne une couche de protection (2) d'une épaisseur prédéterminée après l'application de ce système de couches (3).

11. Procédé selon l'une des revendications précédentes, **caractérisé en ce que** l'on applique sur le deuxième côté (1b) un système de couches qui joue le rôle d'une couche de protection (2) ou **en ce que** l'on utilise un substrat qui présente un tel système de couches et **en ce que** le premier côté (1a) est d'abord traité mécaniquement pour obtenir des propriétés optiques prédéterminées et le système de couches (3) est appliqué ensuite sur le premier côté (1a).

12. Dispositif en vue de l'exécution du procédé selon l'une des revendications précédentes, qui présente une chambre de pulvérisation apte à être placée sous vide et un porte-substrats (5) doté d'éléments (6) de réception de substrats (1) qui permettent de faire tourner les substrats (1) à la fois autour d'un axe d'enroulement orienté essentiellement en parallèle à la surface du substrat et autour d'un axe de rotation orienté essentiellement à la perpendiculaire de la surface du substrat,
**caractérisé en ce que**
l'axe d'enroulement est doté d'un élément d'accouplement qui coopère avec un entraînement d'enroulement (9) de telle sorte qu'un enroulement automatique du substrat (1) permet d'exécuter le procédé sur le premier côté (1a) et le deuxième côté (1b) du substrat (1) sans devoir alimenter en air la chambre de pulvérisation entre les deux opérations.

13. Dispositif selon la revendication 12, **caractérisé en ce qu'**il présente un entraînement (10) commun pour le déplacement de rotation et pour le déplacement d'enroulement.
